# EUROPEAN PATENT APPLICATION

(11) **EP 4 682 654 A1**
(43) Date of publication of application: **21.01.2026**
(21) Application number: 25187076.2
(22) Date of filing: 02.07.2025
(51) Int. Cl.: G05B 19/05, G05B 23/02, G07C 3/00

(54) **OPERATING CONDITION AND HEALTH OF AN APPARATUS**

(30) Priority: 18.07.2024 US 202418777224
(71) Applicant: NXP B.V., 5656 AG Eindhoven (NL)
(72) Inventor: Kaelber, Florian Siegfried, 5656 AG Eindhoven (NL); Lehment, Nicolas Harmen, 5656 AG Eindhoven (NL); Grießbach, Jan, 5656 AG Eindhoven (NL)
(74) Representative: Schmütz, Christian Klaus Johannes

(57) **Abstract**

One example discloses a controller for an apparatus, including: an operational condition monitor configured to determine if the apparatus is in a *known* or *unknown* operating condition in response to a trigger condition; wherein the trigger condition includes the apparatus transitioning from a first operating condition to a second operating condition; and wherein the operational condition monitor is configured to determine if the apparatus in the second operating condition is *healthy* or *unhealthy* in response to the trigger condition.

## Description

The present specification relates to systems, methods, apparatuses, devices, articles of manufacture and instructions for characterizing and/or maintaining an operational health of an apparatus.

### SUMMARY

According to an example embodiment, a controller for an apparatus, comprising: an operational condition monitor configured to determine if the apparatus is in a *known* or *unknown* operating condition in response to a trigger condition; wherein the trigger condition includes the apparatus transitioning from a first operating condition to a second operating condition; and wherein the operational condition monitor is configured to determine if the apparatus in the second operating condition is *healthy* or *unhealthy* in response to the trigger condition.

In another example embodiment, if the second operating condition corresponds to a known operating condition that is *healthy,* then the operational condition monitor is configured to either stop collecting the operating condition data, or fine-tune the known operating condition model.

In another example embodiment, if the second operating condition corresponds to a known operating condition that is *unhealthy,* then the operational condition monitor is configured to send a request to the controller to command the apparatus to either stop the apparatus, or transition the apparatus back to the first operating condition.

In another example embodiment, if the second operating condition is an *unknown* operating condition, then the operational condition monitor is configured to train a new operating condition model for the second operating condition.

In another example embodiment, if the new operating condition model for the apparatus in the second operating condition determines that the apparatus is *healthy,* then the operational condition monitor is configured to further train the new operating condition model.

In another example embodiment, if the new operating condition model for the apparatus in the second operating condition determines that the apparatus is *unhealthy,* then the operational condition monitor is configured to send a request to the controller to command the apparatus to either stop the apparatus, or transition the apparatus back to the first operating condition.

In another example embodiment, the operational condition monitor is configured to record the operating condition data from the apparatus *only when* the apparatus operates within a set of predetermined tolerances for a predetermined period of time.

In another example embodiment, the predetermined tolerances include at least one of: environmental range, a level of vibration, a temperature, a rate of leaking, or a rate of venting.

In another example embodiment, a *healthy* operating condition is defined when the apparatus operates within a set of predetermined tolerances for a predetermined period of time.

In another example embodiment, the *healthy* operating condition is *without any fault conditions.*

In another example embodiment, an *unhealthy* operating condition includes at least one *fault condition.*

In another example embodiment, the fault condition includes at least one of: environmental conditions, out of tolerance conditions, bearing failure, component breakdown, increasing resistances, vibration, overheating, overloading, leaking, or venting.

In another example embodiment, the trigger condition includes a fault detected in the apparatus.

In another example embodiment, the first operating condition is a known operating condition; the second operating condition is an unknown operating condition; the operational condition monitor detects a fault condition in response to the transitioning from the first operating condition to the second operating condition; and the operational condition monitor is configured to send a request to the controller to command the apparatus to transition back to the first operating condition.

In another example embodiment, the first and second operating conditions are defined by a first operational variable and a second operational variable.

In another example embodiment, the apparatus includes is an electric motor; the first operational variable is a motor torque; and the second operational variable is a motor speed.

In another example embodiment, the apparatus is at least one of: a mechanical apparatus, an electrical apparatus, a computational apparatus, a vehicle apparatus, or an environmental apparatus.

In another example embodiment, the operational health device is embedded in a microcontroller.

According to an example embodiment, a method for enabling a controller for an apparatus to be operated, comprising: distributing a set of instructions, stored on a non-transitory, tangible computer readable storage medium, for configuring the controller; wherein the instructions include: determining if the apparatus is in a *known* or *unknown* operating condition in response to a trigger condition; wherein the trigger condition includes the apparatus transitioning from a first operating condition to a second operating condition; and determining if the apparatus in the second operating condition is *healthy* or *unhealthy* in response to the trigger condition.

The above discussion is not intended to represent every example embodiment or every implementation within the scope of the current or future Claim sets. The Figures and Detailed Description that follow also exemplify various example embodiments.

Various example embodiments may be more completely understood in consideration of the following Detailed Description in connection with the accompanying Drawings.

### BRIEF DESCRIPTION OF THE DRAWINGS

**Figure 1** represents an example of ***an operational health system.***
**Figure 2** represents example ***operating conditions*** for the operational health system.
**Figure 3** represents an example ***set of instructions for enabling*** the operational health system.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the scope of the appended claims are covered as well.

### DETAILED DESCRIPTION

Apparatus (e.g. electric and/or mechanical systems, electric motors, data centers, vehicles, etc.) health monitoring is a challenging problem, especially when covering a wide range of operating conditions.

Many apparatuses have ***stationary operational modes*** (e.g. an industrial electric motor with a fixed speed and torque when turned on) and ***non-stationary operational modes*** (e.g. a vehicular electric motor with variable speeds and torques depending upon road conditions).

Current ways of creating health monitors capable of detecting early faults or even failures of such apparatuses under many different operating conditions requires creating vast amounts of data that is then used to train, tune and validate such operational/training models. In some examples, these *training mechanisms* use machine learning (ML) techniques for fault detection.

These resultant health monitors can quickly become unwieldy in real-world use cases due to operational/training model complexity. High false-positive and false-negative fault rates are also common.

These concerns become amplified further if the operational/training models need to be run on resource constrained devices such as edge-connected microcontrollers, having limited memory, power, and compute capability.

Changing environmental and/or operational conditions additionally contribute to these problems. This leads to degrading fault detection accuracy and high false-positive rates of the initially trained and deployed fault detection models. Increased maintenance and bring up times are a consequence.

Now discussed are example embodiments of circuits and controllers for operational state/condition aware selective data capture and modeling for apparatus (e.g. an electric motor) control and/or anomaly/fault detection.

In some example embodiments, an operational condition monitor is added to an apparatus controller which monitors a set of internal apparatus control data (e.g. an electric motor's current draw and rotational speed).

The operational condition monitor records data only or mainly at apparatus operating conditions ideally suited for training, tuning and refining various apparatus health prediction and/or apparatus control models. The operational condition monitor is thus selective in when to record data to avoid biasing or overloading the training mechanisms. Further, by constraining these recording and fault classification diagnostics to smaller operational time windows (e.g. subsections of the possible operating space), there are fewer false positives and computational and power resource needs.

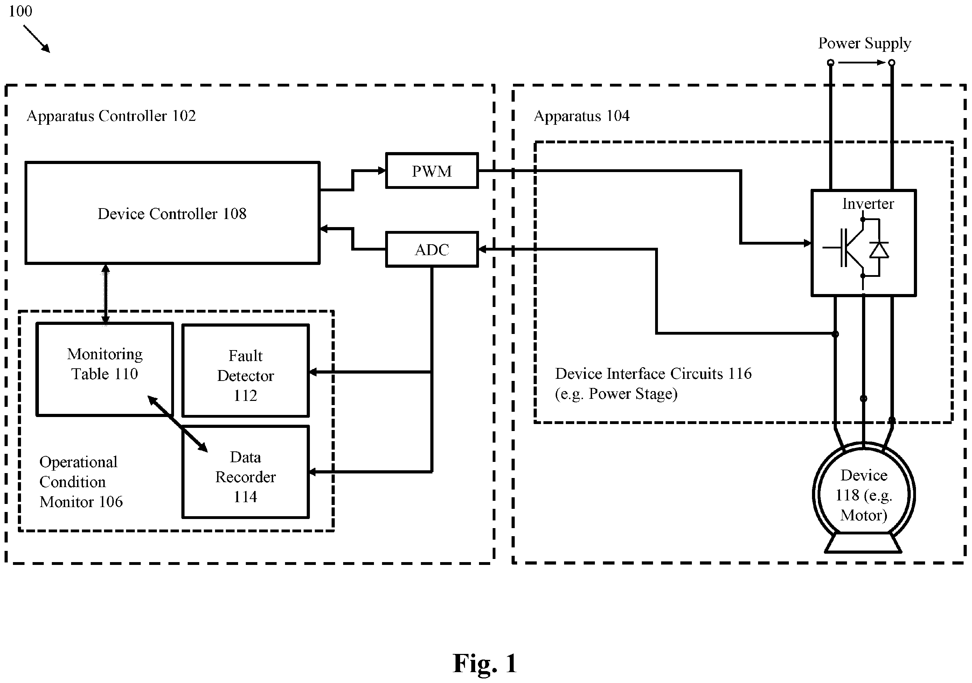

**Figure 1** represents an example of ***an operational health system 100.*** The example operational health system 100 includes an apparatus controller 102 coupled to an apparatus 104.

The apparatus controller 102 includes an operational condition monitor 106, device controller 108, a PWM (pulse width modulation) circuit, and an ADC (analog to digital converter) circuit. The operational condition monitor 106 includes a monitoring table (MT) 110, a fault detector 112, and a data recorder 114. The apparatus 104 includes, in this example embodiment, a set of device interface circuits 116, an inverter, and a device 118 (e.g. motor). The apparatus 104 also receives a power supply.

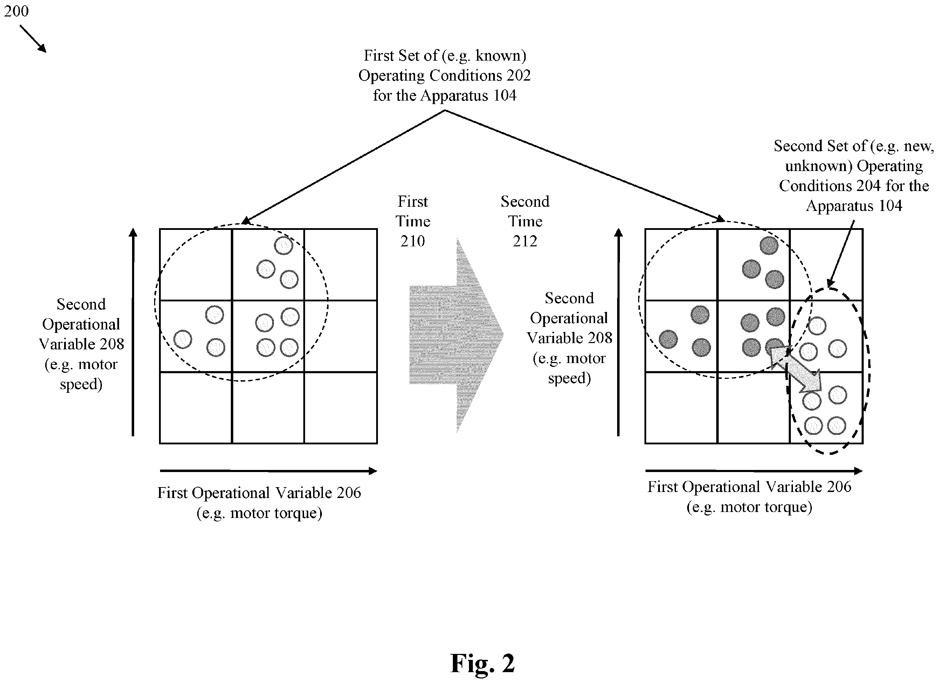

**Figure 2** represents example ***operating conditions 200*** for the operational health system 100. The example operating conditions 200 include a first set of (e.g. known) operating conditions 202 and a second set of (e.g. new and possibly unknown) operating conditions 204.

In this example embodiment, the first and second operating conditions 202, 204 are defined by a first operational variable 206 (e.g. motor torque) and a second operational variable 208 (e.g. motor speed). In other example embodiments, there may be only one operational variable or three or more operational variables, depending upon the application.

The apparatus 104 ***transitions*** between the first set of (e.g. known) operating conditions 202 at a first time 210, to the second set of (e.g. new and possibly unknown) operating conditions 204 at a second Time 212.

**Figure 1** and **Figure 2** are now discussed together in the following paragraphs.

The operational condition monitor 106 is configured to determine if the apparatus 104 is in a ***known*** or ***unknown*** operating condition in response to ***a trigger condition.*** In various example embodiments, the trigger condition may include the apparatus 104 ***transitioning*** from a first operating condition 202 to a second operating condition 204. The operational condition monitor 106 is then configured to determine if the apparatus 104 in the second operating condition 204 is ***healthy*** or ***unhealthy*** in response to the trigger condition.

In some example embodiments, if the second operating condition 204 corresponds to a known operating condition, then then the operational condition monitor 106 can determine if the apparatus 104 is ***healthy*** or ***unhealthy.*** If the apparatus 104 is ***healthy,*** then the operational condition monitor 106 is configured to either stop collecting the operating condition data, or fine-tune the known operating condition model.

Health diagnostic data for anomaly/fault detection, can be obtained using sensors coupled to the apparatus, that is recorded under specific operational conditions and/or transitions. For example, in order to properly generate operational fault models, the operational condition monitor 106 needs to know what is normal (i.e. no unhealthy health diagnostic data from the sensors. Otherwise, fault data could be used for training that could lead to a failure of the apparatus 104 and/or device 118 (e.g. to have a fault model conclude that "bearing failure" is "normal" would not be good).

In other example embodiments, if the second operating condition 204 corresponds to a known operating condition that is ***unhealthy,*** then the operational condition monitor 106 is configured to send a request to the device controller 108 to command the apparatus 104 and/or device 118 to either stop the apparatus 104 and/or device 118, or transition the apparatus 104 and/or device 118 back to the first operating condition 202.

In example embodiments where the second operating condition 204 is an ***unknown*** operating condition, the operational condition monitor 106 does not yet have enough information to determine if the apparatus 104 is ***healthy*** or ***unhealthy since*** a suitable health classifier has not yet been identified and/or created. In such example embodiments, the operational condition monitor 106 is configured to train a ***new*** operating condition classifier/model for the second operating condition that is currently ***unknown.***

Once a ***new*** operating condition classifier/model for the second operating condition has been identified or trained (i.e. becomes a new ***known*** operating condition), then the operational condition monitor 106 can determine if the apparatus 104 is ***healthy*** or ***unhealthy.***

Then, if the second operating condition 204, which is now a ***known*** operating condition, is determined to be ***unhealthy,*** then the operational condition monitor 106 is configured to send a request to the device controller 108 to command the apparatus 104 and/or device 118 to either stop the apparatus 104 and/or device 118, or transition the apparatus 104 and/or device 118 back to the first operating condition 202.

In many example embodiments, the operational condition monitor 106 is configured to use the data recorder 114 to record the operating condition data from the apparatus 104 and/or device 118 ***only when*** the apparatus 104 and/or device 118 operates within ***a set of predetermined tolerances*** for a predetermined period of time.

For example, when operating conditions remain stable within pre-defined bounds over a minimum time, recording is started for either fine-tuning a locally deployed health monitor or for uploading to a cloud infrastructure for further usage in global device training.

In addition, if stable operating conditions within the first operational variable 206 (e.g. motor speed) and the second operational variable 208 (e.g. motor load/torque) for which a set of initial fault detection functions have not been tuned and validated on, then data is recorded. This data could then be utilized to train and/or retrain classification functions (e.g. operating condition model classifiers) and therefore deal efficiently with evolving operating conditions.

In some example embodiments, the operational condition monitor 106 includes the monitoring table (MT) 110 that stores ***specific operating conditions*** (e.g. upper/lower bound, maximum fluctuation, maximum change etc.) together with a set of ***minimum stable times (MSTs)*** for each entry.

For example, there can be two MST values (e.g. MST1 and MST2). Each entry in the monitoring table (MT) 110 represents an envelope of operating conditions for which the system designer has tuned and validated a set of diagnostic/fault functions. The monitoring table (MT) 110 may specify additional parameters to be applied to diagnostic functions associated with each entry.

The operational condition monitor 106 observes data from the apparatus control loop and checks whether the data ***matches*** conditions under one of the entries in the MT 110 and if the fault detection model for the fault detector 112 needs tuning for that entry.

If there is a ***match,*** a stable conditions timer is started. The timer is incremented as long as conditions remain stable and reset once conditions leave the envelope defined in the currently monitored MT entry.

Once the MST1 threshold is passed, the recorded data is written to memory and used for operational model tuning; once the MST2 threshold is passed, the recording is stopped. If the MST2 is not passed due to changing apparatus 104 and/or device 118 operating conditions, the recording is discarded, and the operational condition monitor 106 waits until operating conditions ***match*** again with one of the entries in the MT 110.

If there is not a match with an entry in the monitoring table (MT) 110, then this is *a* ***new*/*unseen*/*unknown*** operating state 204, and ***a new classifier*/*model is trained*** with a set of newly recorded data.

However, before usage, the newly trained classifier is validated by ***a health check*** during apparatus 104 operation on an already previously known operating state, for which health metrics from existing classifiers can be derived.

For example embodiments where the device 118 is an electric motor, health sensors attached to the electric motor can detect for any fault conditions, such as vibration due to bearing failure, increased binding, or increased windings resistance. Such health sensors can be added or reused to detect general gear-box, drive-train and/or vehicle fault conditions as well. Thus coupling between various computational, mechanical and/or electrical system components can be detected using a large number of or just a few health sensors, depending upon the application.

Once this new classifier is validated, it's associated ranges may be added to the MT 110. In various example embodiments, entries to the MT 110 are uploaded to cloud services for further usage in larger device fleet applications.

In various example embodiments, to stay within the limited memory and computation capacities of a microcontroller (MCU) hosting the apparatus controller 102, a two-step machine learning pipeline consisting of parts A and B can be used. Part A could be a universally used backbone which serves as feature extractor. A's output is the fed into part B. Part B can provide several classifiers (e.g. support vector machine, self-organizing map,) which are specialized on the different operating conditions. Every new recording is immediately processed with the backbone A such that only the heavily in sized reduced feature representation is saved as a sample on the MCU memory. Once enough samples are collected, a classifier from part B can be retrained or finetuned on the MCU.

To summarize, the operational condition monitor 106 monitors health and operational mode ***information from the apparatus 104 and*/*or device 118*** and then ***trigger*** s data recording functions ***only when*** the apparatus ***104 and*/*or device 118*** runs in operating ***states well suited for*** training or fine-tuning of a set of fault detection models. If new/unseen/unknown operating states are encountered, then ***data recording*** is triggered as well and new fault detection models are created for those new states.

In some example embodiments, the predetermined tolerances may include at least one of: environmental range, a level of vibration, a temperature, a rate of leaking, or a rate of venting.

In most example embodiments, a ***healthy*** apparatus is defined as operating without any fault conditions, and the ***unhealthy*** apparatus includes at least one fault condition. If the device 118 is an electric motor, then the fault conditions may include at least one of: environmental conditions, out of tolerance conditions, bearing failure, component breakdown, increasing resistances, vibration, overheating, overloading, leaking, or venting. If the device 118 is something different, then another set of application specific fault conditions are defined.

Using the operational condition monitor 106, operational/training models can be trained, fine-tuned, and/or retrained locally (e.g. at the edge proximate to the apparatus) without a need for network communications with a remote a server.

In some example embodiments, the apparatus control loops run on a microcontroller (MCU) providing function blocks such as pulse width modulating (PWM) outputs and analog digital converters (ADCs) to execute a field-oriented control (FOC) of the connected apparatus. Optionally encoders could be used too.

For example embodiments where the apparatus is an electric motor (such as shown in **Figure 1****),** the motor's current draw data can be obtained either by reading from the ADC buffer feeding the apparatus control loops or by connecting a separate ADC (e.g. an N-AFE Analog Front End) via a SPI interface. In case we read from the internal ADC, we might reduce the effective sampling rate by reading only every tenth frame or so - the operational condition monitor 106 needs much less time resolution than the apparatus control loop.

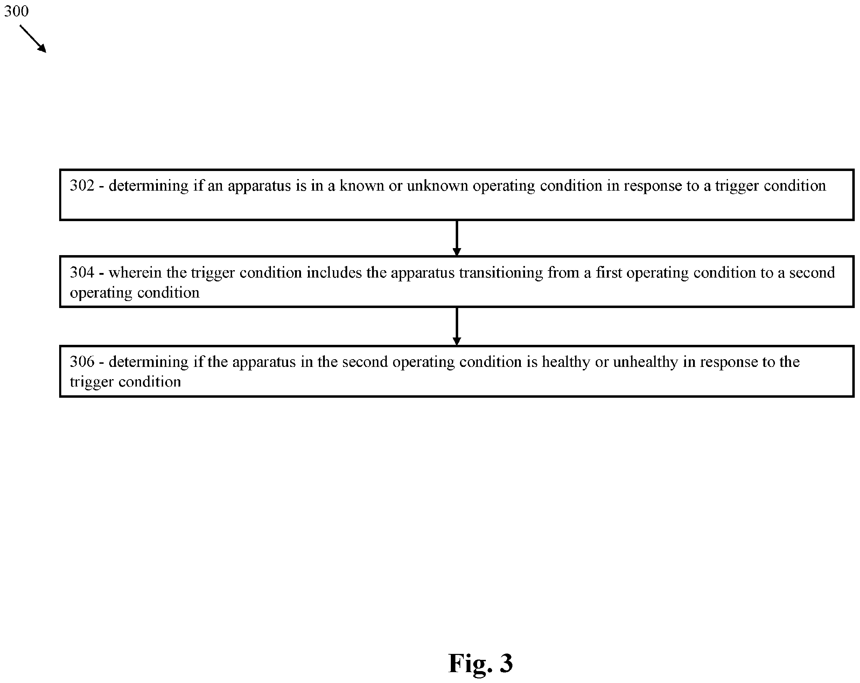

**Figure 3** represents an example set of instructions 300 for enabling the operational health system 100. The order in which the instructions are discussed does not limit the order in which other example embodiments implement the instructions unless otherwise specifically stated. Additionally, in some embodiments the instructions are implemented concurrently.

A first example instruction set begins in 302, by determining if the apparatus is in *a* ***known* or *unknown*** operating condition in response to a trigger condition. Next, in 304, wherein the trigger condition includes the apparatus transitioning from a first operating condition to a second operating condition. Then in 306 determining if the apparatus in the second operating condition is healthy or unhealthy in response to the trigger condition.

Various systems, such as the apparatus controller 102 and/or the operational condition monitor 106 discussed earlier, can host these instructions. Such systems can include an input/output data interface, a processor, a storage device, and a non-transitory machine-readable storage medium. The machine-readable storage medium includes the instructions which control how the processor receives input data and transforms the input data into output data, using data within the storage device. The machine-readable storage medium in an alternate example embodiment is a non-transitory computer-readable storage medium. In other example embodiments the set of instructions described above can be implemented either using logic gates, application specific chips, firmware, as well as other hardware forms.

In some example embodiments the set of instructions described above are implemented as functional and software instructions. In other embodiments, the instructions can be implemented either using logic gates, application specific chips, firmware, as well as other hardware forms.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

In this specification, example embodiments have been presented in terms of a selected set of details. However, a person of ordinary skill in the art would understand that many other example embodiments may be practiced which include a different selected set of these details. It is intended that the following claims cover all possible example embodiments.

It will be readily understood that the components of the embodiments as generally described herein and illustrated in the appended figures could be arranged and designed in a wide variety of different configurations. Thus, the detailed description of various embodiments, as represented in the figures, is not intended to limit the scope of the present disclosure, but is merely representative of various embodiments. While the various aspects of the embodiments are presented in drawings, the drawings are not necessarily drawn to scale unless specifically indicated.

The present invention may be embodied in other specific forms without departing from its essential characteristics. The described embodiments are to be considered in all respects only as illustrative and not restrictive. The scope of the invention is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present invention should be or are in any single embodiment of the invention. Rather, language referring to the features and advantages is understood to mean that a specific feature, advantage, or characteristic described in connection with an embodiment is included in at least one embodiment of the present invention. Thus, discussions of the features and advantages, and similar language, throughout this specification may, but do not necessarily, refer to the same embodiment.

Furthermore, the described features, advantages, and characteristics of the invention may be combined in any suitable manner in one or more embodiments. One skilled in the relevant art will recognize, in light of the description herein, that the invention can be practiced without one or more of the specific features or advantages of a particular embodiment. In other instances, additional features and advantages may be recognized in certain embodiments that may not be present in all embodiments of the invention.

Reference throughout this specification to "one embodiment," "an embodiment," or similar language means that a particular feature, structure, or characteristic described in connection with the indicated embodiment is included in at least one embodiment of the present invention. Thus, the phrases "in one embodiment," "in an embodiment," and similar language throughout this specification may, but do not necessarily, all refer to the same embodiment.

## Claims

1. A controller for an apparatus, comprising:
an operational condition monitor configured to determine if the apparatus is in a known or unknown operating condition in response to a trigger condition;
wherein the trigger condition includes the apparatus transitioning from a first operating condition to a second operating condition; and
wherein the operational condition monitor is configured to determine if the apparatus in the second operating condition is healthy or unhealthy in response to the trigger condition.

2. The controller of claim 1:
wherein if the second operating condition corresponds to a known operating condition that is healthy, then the operational condition monitor is configured to either stop collecting the operating condition data, or fine-tune the known operating condition model.

3. The controller of claim 1 or 2:
wherein if the second operating condition corresponds to a known operating condition that is unhealthy, then the operational condition monitor is configured to send a request to the controller to command the apparatus to either stop the apparatus, or transition the apparatus back to the first operating condition.

4. The controller of any of the preceding claims:
wherein if the second operating condition is an unknown operating condition, then the operational condition monitor is configured to train a new operating condition model for the second operating condition.

5. The controller of any of the preceding claims:
wherein if the new operating condition model for the apparatus in the second operating condition determines that the apparatus is healthy, then the operational condition monitor is configured to further train the new operating condition model.

6. The controller of any of the preceding claims:
wherein if the new operating condition model for the apparatus in the second operating condition determines that the apparatus is unhealthy, then the operational condition monitor is configured to send a request to the controller to command the apparatus to either stop the apparatus, or transition the apparatus back to the first operating condition.

7. The controller of any of the preceding claims:
wherein the operational condition monitor is configured to record the operating condition data from the apparatus only when the apparatus operates within a set of predetermined tolerances for a predetermined period of time.

8. The controller of claim 7:
wherein the predetermined tolerances include at least one of: environmental range, a level of vibration, a temperature, a rate of leaking, or a rate of venting.

9. The controller of any of the preceding claims:
wherein a healthy operating condition is defined when the apparatus operates within a set of predetermined tolerances for a predetermined period of time.

10. The controller of claim 9:
wherein the healthy operating condition is without any fault conditions.

11. The controller of any of the preceding claims:
wherein an unhealthy operating condition includes at least one fault condition.

12. The controller of claim 11:
wherein the fault condition includes at least one of: environmental conditions, out of tolerance conditions, bearing failure, component breakdown, increasing resistances, vibration, overheating, overloading, leaking, or venting.

13. The controller of any of the preceding claims:
wherein the trigger condition includes a fault detected in the apparatus.

14. The controller of any of the preceding claims:
wherein the first operating condition is a known operating condition;
wherein the second operating condition is an unknown operating condition;
wherein the operational condition monitor detects a fault condition in response to the transitioning from the first operating condition to the second operating condition; and
wherein the operational condition monitor is configured to send a request to the controller to command the apparatus to transition back to the first operating condition.

15. Method for enabling a controller for an apparatus to be operated, comprising:
distributing a set of instructions, stored on a non-transitory, tangible computer readable storage medium, for configuring the controller;
wherein the instructions include:
determining if the apparatus is in a known or unknown operating condition in response to a trigger condition;
wherein the trigger condition includes the apparatus transitioning from a first operating condition to a second operating condition; and
determining if the apparatus in the second operating condition is healthy or unhealthy in response to the trigger condition.
